# EUROPEAN PATENT APPLICATION

(11) **EP 4 089 745 A1**
(43) Date of publication of application: **16.11.2022**
(21) Application number: 21173205.2
(22) Date of filing: 11.05.2021
(51) Int. Cl.: H01L 33/38, H01L 33/44, H01L 33/40

(54) **LIGHT-EMITTING DIODE CHIP STRUCTURE**

(71) Applicant: Excellence Opto. Inc., Miaoli County 35053 (TW)
(72) Inventor: CHEN, Fu-Bang, 35053 Miaoli County, Hsinchu Science Park (TW); HUANG, Kuo-Hsin, 35053 Miaoli County, Hsinchu Science Park (TW)
(74) Representative: 2K Patentanwälte Blasberg Kewitz & Reichel

(57) **Abstract**

A light-emitting diode chip structure comprising a substrate (10); a metal contact layer (20) disposed on the substrate (10); a light-emitting semiconductor layer (30) disposed on the metal contact layer (20); an insulating protective layer (40) covering the metal contact layer (20) and the light-emitting diode semiconductor layer. The insulating protective layer (40) includes a first opening (41) that exposes the light-emitting semiconductor layer (30) and a second opening (42) that exposes the metal contact layer (20). The metal conductive layer (50) with one end passing through the first opening (41) to be electrically connected to the light-emitting semiconductor layer (30), and the other end of the metal conductive layer (50) extended on the insulating protective layer (40). A first electrode pad (60) and a second electrode pad (70) are respectively located on lateral sides of the light-emitting semiconductor layer (30) and respectively disposed on the metal conductive layer (50) and passing through the second opening (42) to be disposed on the metal contact layer (20).

## Description

### FIELD OF THE INVENTION

The invention relates to light-emitting diodes, more particularly to a light-emitting diode chip structure.

### BACKGROUND OF THE INVENTION

In the conventional vertical light-emitting diode, the chip structure includes an N-type semiconductor layer, a quantum well, and a P-type semiconductor layer forming as a sandwich structure. A bonding layer, a silicon substrate, and a P-type electrode are sequentially disposed under the P-type semiconductor layer. A surface of the N-type semiconductor layer is provided for disposing an N-type electrode. Accordingly, after applying voltage to the N-type electrode and the P-type electrode, the N-type semiconductor layer provides electrons, and the P-type semiconductor layer provides electron holes. The electrons and the electron holes are combined in the light-emitting layer to generate light. The vertical light-emitting diode has characteristics of high axial light and excellent heat dissipation, which provide great advantages in color rendering in display unit. However, if applied to mini-LED display unit, due to the small size of the chip, that the size of a single-color chip is 50µm to 200µm in the shortest side length, the electrode pad on the light-emitting surface has a problem of causing severe shading; and the chip needs to be processed with both the wiring process of the light-emitting surface and the high-conductivity chip bonding process at the bottom, and thus the overall process is more complicated.

In the above-mentioned structure, for special applications where insulation is required at the bottom or in order to reduce the complexity of the process, the P-type semiconductor layer can be connected to a metal contact layer, and the P-type electrode can be moved to a lateral position of the light-emitting layer, the P-type electrode is then connected to the metal contact layer, which can still maintain high axial light characteristic and meet the requirements of high color rendering display unit. This type of chip is called lateral LED chip, as shown in FIG. 1 of the US patent No. US 10,304,998 B2.

In addition, in order to improve the shading phenomenon of the electrode pad on the light-emitting surface, the size of the electrode pad is reduced. However, when the wire bonding method is used to connect the electrical circuit, the corresponding small-sized electrode pad will use a small wire bonding head. Under the constant force (F), because the force area (A) of wire bonding becomes smaller, at this time, the stress (P) borne by the electrode pad becomes larger (P=F/A). Therefore, the wire bonding process is likely to cause rupture of the semiconductor that emits light under the electrode pad. Generally speaking, it will increase the leakage current, and will cause dark spots in severe cases. In addition to affecting the photoelectric characteristics of the device (decreased luminous efficiency), it will affect the long-term reliability of the photoelectric device.

### SUMMARY OF THE INVENTION

Therefore, a main object of the invention is to provide a light-emitting diode chip structure that does not damage a semiconductor structure during a wire bonding process.

The invention provides a light-emitting diode chip structure comprising a substrate, a metal contact layer, a light-emitting semiconductor layer, an insulating protective layer, a metal conductive layer, a first electrode pad and a second electrode pad. The metal contact layer is disposed on the substrate, the light-emitting semiconductor layer is disposed on the metal contact layer, the insulating protective layer covers the metal contact layer and the light-emitting diode semiconductor layer, and the insulating protective layer includes a first opening and a second opening. The first opening exposes the light-emitting semiconductor layer, and the second opening exposes the metal contact layer. The metal conductive layer is disposed on the insulating protective layer. One end of the metal conductive layer passes through the first opening to be electrically connected to the light-emitting semiconductor layer, and the other end of the metal conductive layer is extended on a horizontal plane of the metal contact layer where the light-emitting semiconductor layer is not disposed thereon.

The first electrode pad is disposed on the metal conductive layer and located on the lateral side of the light-emitting semiconductor layer. The second electrode pad passes through the second opening to be disposed on the metal contact layer and is located on one lateral side of the light-emitting semiconductor layer.

Accordingly, the invention has high axial light characteristic to meet the requirements of high color rendering display unit considering the structure design as a vertical light-emitting diode. In addition, since the first electrode pad and the second electrode pad are respectively disposed on the lateral sides of the light-emitting semiconductor layer, the problem of shading by the electrodes causing a brightness to drop significantly can be improved, and the problem of rupture of the light-emitting semiconductor layer caused by stress during the wire bonding process can be eliminated. Furthermore, disposing heights of the first electrode pad and the second electrode pad are similar, which facilitate performing of wire bonding process. In addition, the substrate can be made of high heat dissipation material with characteristic of excellent heat dissipation.

### BRIEF DESCRIPTION OF THE DRAWINGS

FIG. 1 is a cross-sectional side view of a first embodiment of the invention;
FIG. 2 is a top view of the first embodiment of the invention;
FIG. 3 is a cross-sectional side view of a second embodiment of the invention;
FIG. 4 is a top view of the second embodiment of the invention;
FIG. 5 is a cross-sectional side view of a third embodiment of the invention;
FIG. 6 is a top view of a fourth embodiment of the invention; and
FIG. 7 is a top view of a fifth embodiment of the invention.

### DETAILED DESCRIPTION OF THE PREFERRED EMBODIMENTS

In order to make the above and other objects, features and advantages of the present invention more comprehensible, five preferred embodiments will be described in detail with reference to the accompanying drawings hereafter.

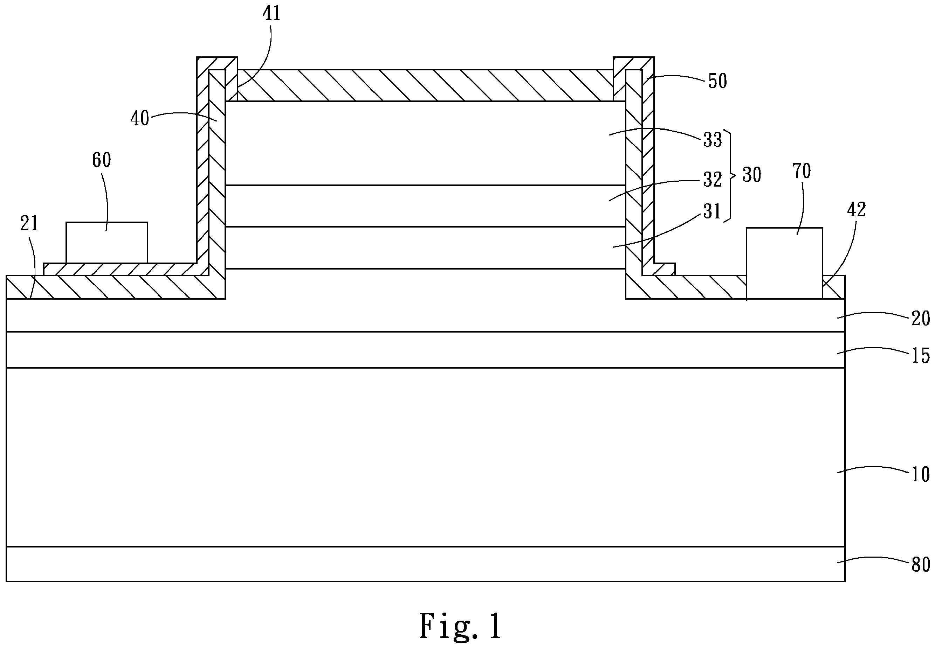

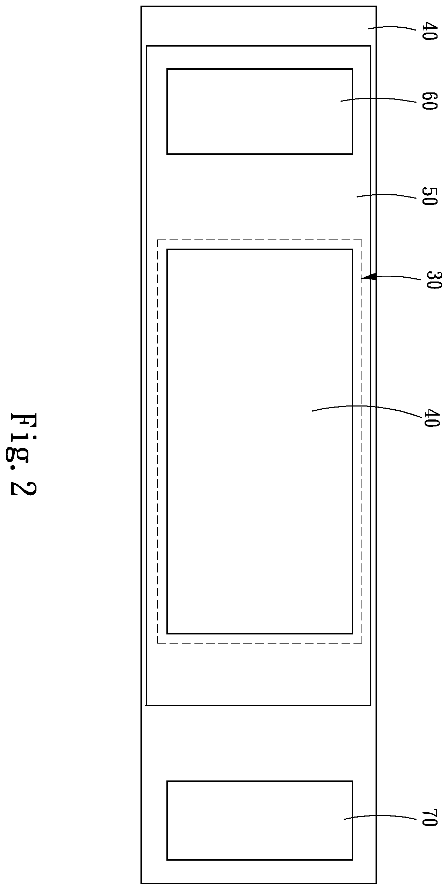

It should be noted that the present invention is not limited to the embodiments herein and can be realized by various forms. Further, the drawings are not precise scales. Please refer to FIG. 1 and FIG. 2 for a first embodiment of the invention. The invention provides a light-emitting diode chip structure comprising a substrate 10, a metal contact layer 20, a light-emitting semiconductor layer 30, an insulating protective layer 40, a metal conductive layer 50, a first electrode pad 60, and a second electrode pad 70. The metal contact layer 20 is disposed on the substrate 10. In this embodiment, the substrate 10 and the metal contact layer 20 are fixed by an adhesive layer 15. The substrate 10 is selected from any one of conductive materials, such as P-Type Si substrate, CuMoCu substrate, and Ni-Fe substrate. Alternatively, the substrate 10 is selected from any one of materials with high thermal conductivity, such as SiC substrate, AlN substrate, and Al₂O₃ substrate. In addition, a bottom contact layer 80 with magnetism is disposed under the substrate 10. A material of the bottom contact layer 80 is selected from any one of the group consisting of ferromagnetic film, polymer with ferromagnetic material powder, and ceramic with ferromagnetic material powder. In detail, the ferromagnetic film and the ferromagnetic material powder is made of ferromagnetic materials such as iron, nickel and cobalt.

The light-emitting semiconductor layer 30 includes a P-type semiconductor layer 31, a quantum well 32 and an N-type semiconductor layer 33 stacked in sequence. The light-emitting semiconductor layer 30 is disposed on the metal contact layer 20. The P-type semiconductor layer 31 is electrically connected to the metal contact layer 20. The insulating protective layer 40 covers the metal contact layer 20 and the light-emitting semiconductor layer 30. A material of the insulating protective layer 40 is selected from a group consisting of SiO₂, SiN, SiN/SiO₂/SiN, TiO₂ and TiO₂/SiO₂/TiO₂. The insulating protective layer 40 includes a first opening 41 and a second opening 42. The first opening 41 exposes the light-emitting semiconductor layer 30, and the second opening 42 exposes the metal contact layer 20. Further, the first opening 41 is disposed to surround a contour edge of the light-emitting semiconductor layer 30.

The metal conductive layer 50 is disposed on the insulating protective layer 40, and one end of the metal conductive layer 50 passes through the first opening 41 to be electrically connected to the light-emitting semiconductor layer 30. In more detail, the metal conductive layer 50 covers lateral sides of the light-emitting semiconductor layer 30, the metal conductive layer 50 is electrically connected to the contour edge of the light-emitting semiconductor layer 30, and the N-type semiconductor layer 33 of the light-emitting semiconductor layer 30 is electrically connected to the metal conductive layer 50. The other end of the metal conductive layer 50 is extended on a horizontal plane 21 of the metal contact layer 20 where the light-emitting semiconductor layer 30 is not disposed thereon.

Furthermore, the first electrode pad 60 is disposed on the metal conductive layer 50 and located on one lateral side of the light-emitting semiconductor layer 30. The second electrode pad 70 passes through the second opening 42 to be disposed on the metal contact layer 20 and located on one lateral side of the light-emitting semiconductor layer 30. In this embodiment, the first electrode pad 60 and the second electrode pad 70 are located on different lateral sides of the light-emitting semiconductor layer 30 to have a larger linear distance in order to reduce the difficulty of the subsequent wire bonding process.

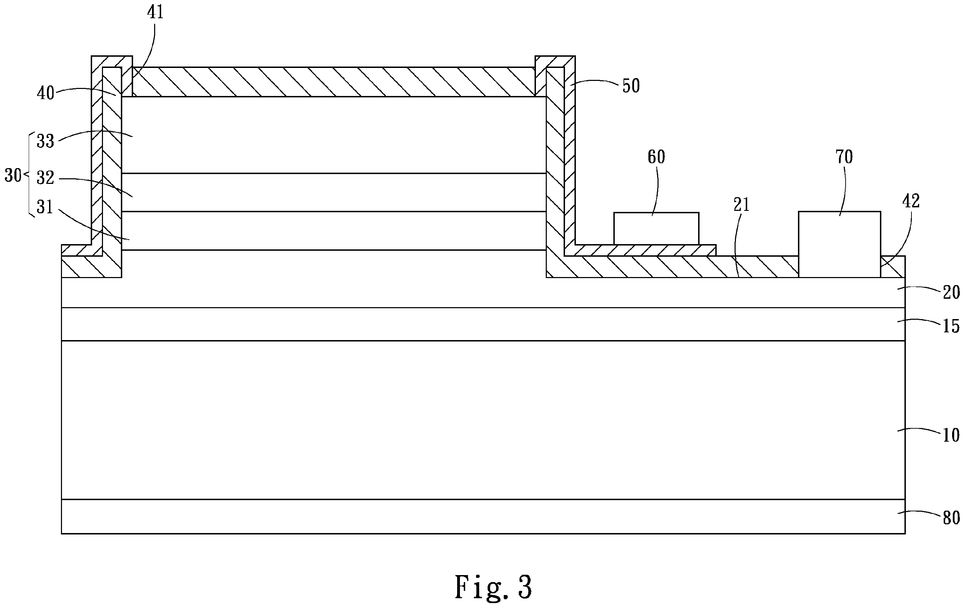

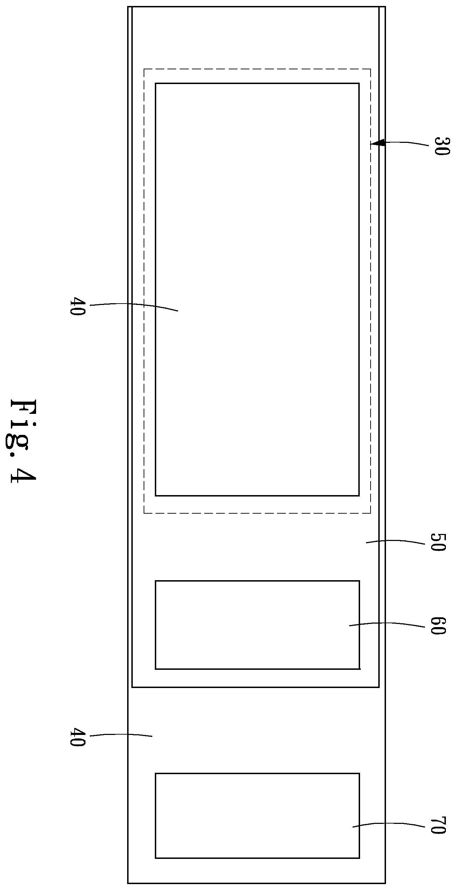

Please refer to FIG. 3 and FIG. 4 for a second embodiment of the invention. Compared with the first embodiment, the first electrode pad 60 and the second electrode pad 70 are located on the same lateral side of the light-emitting semiconductor layer 30. Accordingly, the first electrode pad 60 and the second electrode pad 70 are located adjacent with each other and have similar heights. For high-precision and double-headed wire bonding equipment, wire bonding operation of the first electrode pad 60 and the second electrode pad 70 can be completed in one time, thereby saving the wire bonding time.

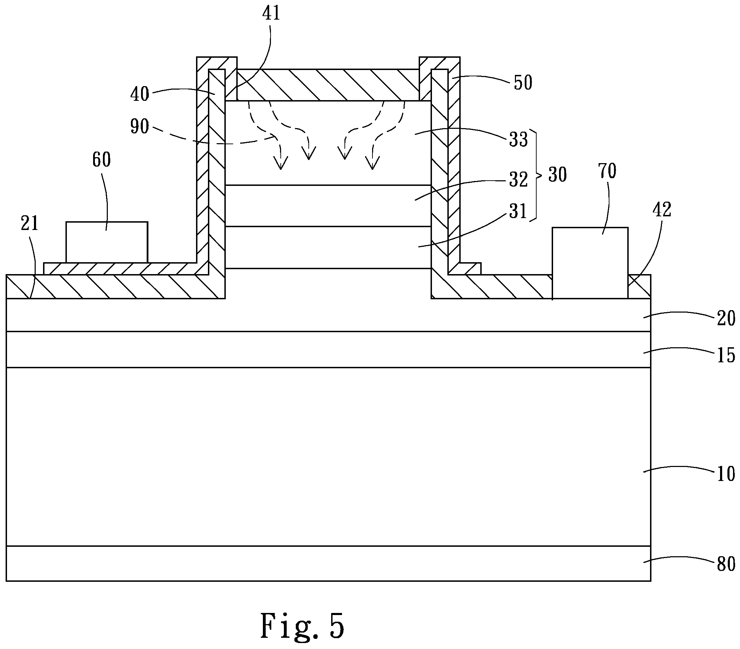

Please refer to FIG. 5 for a third embodiment of the invention. For the consideration of light emission uniformity of the light-emitting semiconductor layer 30, the contour edge of the light-emitting semiconductor layer 30 is rectangular, and an area of the light-emitting semiconductor layer 30 is less than 50000µm². That is, a size of the light-emitting semiconductor layer 30 cannot be too large, so that a current 90 flowing through the N-type semiconductor layer 33 has a sufficient diffusion path. Furthermore, the contour edge of the light-emitting semiconductor layer 30 is rectangular. A length of a long side of the light-emitting semiconductor layer 30 is defined as W; a height of the N-type semiconductor layer 33 is defined as H, wherein W/H is less than 75. Thereby, the current 90 flowing through the N-type semiconductor layer 33 is sufficiently diffused to allow the light-emitting semiconductor layer 30 to emit light uniformly.

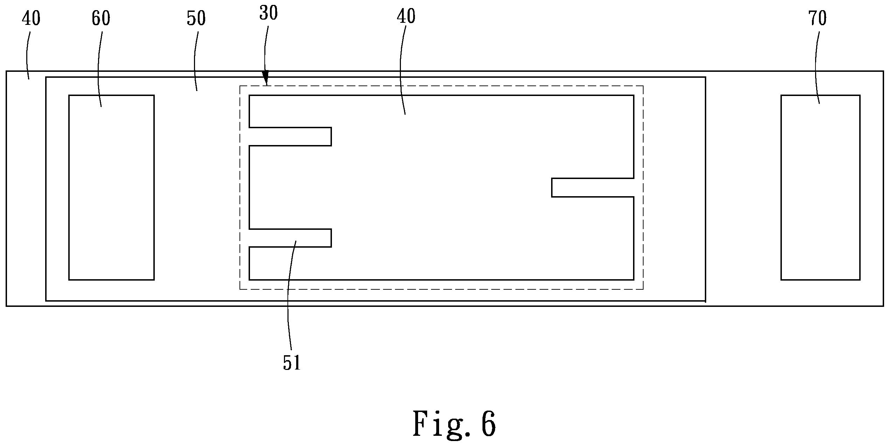

Please refer to FIG. 6 for a fourth embodiment of the invention. If a size of the light-emitting semiconductor layer 30 is too large, the metal conductive layer 50 further includes an auxiliary circuit 51 extending to reach a middle area of the light-emitting semiconductor layer 30. As guided by the auxiliary circuit 51, the current 90 (as shown in FIG. 5) is further diffused to allow the light-emitting semiconductor layer 30 to emit light uniformly. Besides, the auxiliary circuit 51 is disposed to span across the light-emitting semiconductor layer 30 (not shown in the figure), or extend crisscross to reach above the light-emitting semiconductor layer 30 (as shown in FIG. 6).

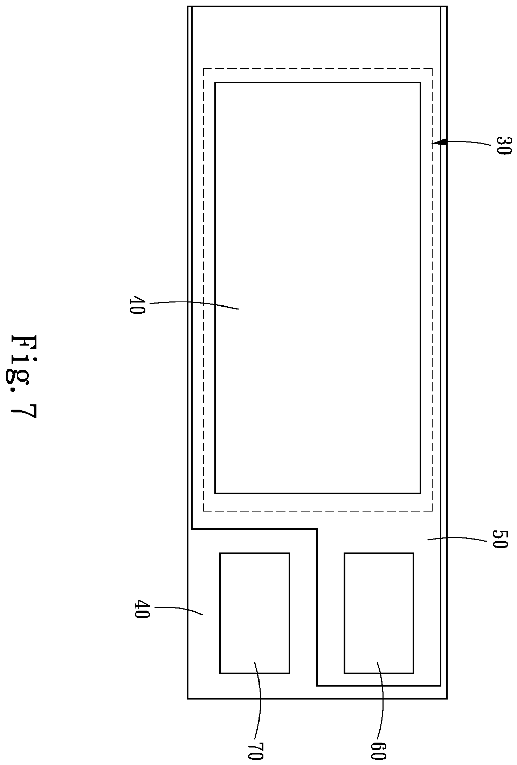

Please refer to FIG. 7 for a fifth embodiment of the invention. Compared with the second embodiment, in addition to the first electrode pad 60 and the second electrode pad 70 locating on the same lateral side of the light-emitting semiconductor layer 30, the first electrode pad 60 and the second electrode pad 70 are further arranged in parallel along a longitudinal direction. With this design, sizes of the first electrode pad 60 and the second electrode pad 70 are small, so precision wire bonding equipment is required for wire bonding.

In summary, the invention includes the following advantages:
1. Adopted the structure design of vertical light-emitting diode, the invention has a high axial light characteristic to meet the requirements of high color rendering display unit.
2. The first electrode pad and the second electrode pad are respectively disposed on the lateral sides of the light-emitting semiconductor layer to improve the problem of shading by the electrodes causing a brightness to drop significantly.
3. Since the light-emitting semiconductor layer is not provided under the first electrode pad and the second electrode pad, the problem of rupture of the light-emitting semiconductor layer caused by stress is eliminated.
4. The heights of the first electrode pad and the second electrode pad are similar, which facilitate performing of wire bonding process.
5. The substrate is made of high heat dissipation material with characteristic of excellent heat dissipation.
6. The bottom contact layer with magnetism is provided on a bottom of the substrate, which is suitable for magnetic transfer process and facilitates large-scale transfer of small-sized chips.

## Claims

1. A light-emitting diode chip structure comprising:
a substrate (10);
a metal contact layer (20), the metal contact layer (20) disposed on the substrate (10);
a light-emitting semiconductor layer (30), the light-emitting semiconductor layer (30) disposed on the metal contact layer (20);
an insulating protective layer (40), the insulating protective layer (40) covering the metal contact layer (20) and the light-emitting semiconductor layer (30), and the insulating protective layer (40) including a first opening (41) exposing the light-emitting semiconductor layer (30), and a second opening (42) exposing the metal contact layer (20);
a metal conductive layer (50), the metal conductive layer (50) disposed on the insulating protective layer (40), one end of the metal conductive layer (50) passing through the first opening (41) to be electrically connected to the light-emitting semiconductor layer (30), and the other end of the metal conductive layer (50) extended on a horizontal plane (21) of the metal contact layer (20) where the light-emitting semiconductor layer (30) is not disposed thereon;
a first electrode pad (60), the first electrode pad (60) disposed on the metal conductive layer (50) and located on one lateral side of the light-emitting semiconductor layer (30); and
a second electrode pad (70), the second electrode pad (70) passing through the second opening (42) to be disposed on the metal contact layer (20) and located on one lateral side of the light-emitting semiconductor layer (30).

2. The light-emitting diode chip structure as claimed in claim 1, wherein the first opening (41) surrounds a contour edge of the light-emitting semiconductor layer (30), and the metal conductive layer (50) is electrically connected to the contour edge of the light-emitting semiconductor layer (30).

3. The light-emitting diode chip structure as claimed in claim 1 or 2, wherein the metal conductive layer (50) covers lateral sides of the light-emitting semiconductor layer (30).

4. The light-emitting diode chip structure as claimed in claim 3, wherein the metal conductive layer (50) includes an auxiliary circuit (51) extending to reach a middle area of the light-emitting semiconductor layer (30).

5. The light-emitting diode chip structure as claimed in any of the claims 1 to 4, wherein a contour edge of the light-emitting semiconductor layer (30) is rectangular, and an area of the light-emitting semiconductor layer (30) is less than 50000µm².

6. The light-emitting diode chip structure as claimed in any of the claims 1 to 5, wherein the lateral side of the first electrode pad (60) and the lateral side of the second electrode pad (70) are located on a same side of the light-emitting semiconductor layer (30).

7. The light-emitting diode chip structure as claimed in claim 6, wherein the first electrode pad (60) and the second electrode pad (70) are arranged in parallel along a longitudinal direction.

8. The light-emitting diode chip structure as claimed in any of the claims 1 to 7, wherein the lateral side of the first electrode pad (60) and the lateral side of the second electrode pad (70) are located on different sides of the light-emitting semiconductor layer (30).

9. The light-emitting diode chip structure as claimed in any of the claims 1 to 8, wherein the substrate (10) and the metal contact layer (20) are fixed by an adhesive layer (15).

10. The light-emitting diode chip structure as claimed in any of the claims 1 to 9, wherein a bottom contact layer (80) with magnetism is disposed under the substrate (10).

11. The light-emitting diode chip structure as claimed in claim 10, wherein a material of the bottom contact layer (80) is selected from any one of the group consisting of ferromagnetic film, polymer with ferromagnetic material powder, and ceramic with ferromagnetic material powder.

12. The light-emitting diode chip structure as claimed in any of the claims 1 to 11, wherein the light-emitting semiconductor layer (30) includes a P-type semiconductor layer (31), a quantum well (32) and an N-type semiconductor layer (33) stacked in sequence, wherein the P-type semiconductor layer (31) is electrically connected to the metal contact layer (20), the N-type semiconductor layer (33) is electrically connected to the metal conductive layer (50), a contour edge of the light-emitting semiconductor layer (30) is rectangular, and wherein a length of a long side of the light-emitting semiconductor layer (30) is defined as W, a height of the N-type semiconductor layer (33) is defined as H, and W/H is less than 75.
